Europäisches Patentamt

European Patent Office

Office européen des brevets

(19)

(11) Publication number: **0 027 289**
**B1**

## EUROPEAN PATENT SPECIFICATION

(12)

(45) Date of publication of patent specification: **20.07.83**

(21) Application number: **80200942.3**

(22) Date of filing: **06.10.80**

(51) Int. Cl.³: **H 04 L 7/02,** H 04 B 12/02,
H 03 D 13/00

(54) Digital signal transmission system.

(30) Priority: **10.10.79 GB 7935109**

(43) Date of publication of application:
**22.04.81 Bulletin 81/16**

(45) Publication of the grant of the patent:
**20.07.83 Bulletin 83/29**

(84) Designated Contracting States:
**DE FR GB SE**

(56) References cited:
**DE - B - 1 906 076**
**GB - A - 1 475 803**
**GB - A - 1 541 089**
**GB - A - 1 552 739**
**US - A - 4 160 217**

**K. TRÖNDLE, R. WEISS "Einführung in die Puls-
Code-Modulation", 1974, R. Oldenbourg Verlag
GmbH, München, pages 140—148+Fig. 54,
56+**

(73) Proprietor: **PHILIPS ELECTRONIC AND
ASSOCIATED INDUSTRIES LIMITED
Abacus House 33 Gutter Lane
London EC2V 8AH (GB)**
(84) **GB**
(73) Proprietor: **N.V. Philips' Gloeilampenfabrieken
Groenewoudseweg 1
NL-5621 BA Eindhoven (NL)**
(84) **DE FR SE**

(72) Inventor: **Hughes, John Barry c/o Patent
Department
Philips Industries Mullard House Torrington Place
London WC1E 7HD (GB)**

(74) Representative: **Boxall, Robin John et al,
Philips Electronic and Associated Ind. Ltd. Patent
Department Mullard House Torrington Place
London WC1E 7HD (GB)**

Courier Press, Leamington Spa, England.

## Digital signal transmission system

The present invention relates to digital signal transmission systems particularly, but not exclusively, for use at high bit rates in the Gigabit per second range.

In digital transmission systems using transmission media such as coaxial cables and optical fibres it is necessary to regenerate the signal being transmitted at various intervals and ultimately to de-multiplex the signal at the terminus of the transmission medium. At bit rates up to 500 Megabits/second the signal regeneration can be carried out using known ECL logic families. However 500 Megabits/second represents the typical maximum switching speed for known ECL logic families and accordingly other techniques are necessary when working at higher bit rates.

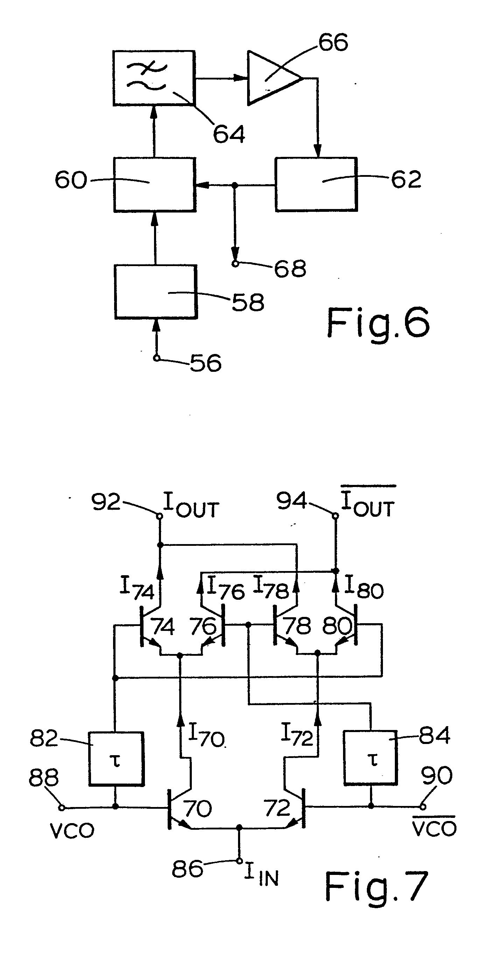

It has now been realised that the regeneration of signals and demultiplexing of signals in the Gigabit/second range and below can be carried out using circuit techniques based on multiplexers, for example the multiplexer disclosed in Figure 6 of British Patent Specification No. 1,552,739 (PHB 32601) the details of which are incorporated herein by way of reference. Since it is possible to switch a multiplexer on each zero crossover of a clock signal then the clock signal need only have a frequency of half that customarily necessary when using known ECL circuit elements such as decision circuits for retiming signals and demultiplexers which normally require a clock frequency the same as that of the bit rate. Consequently the known elements are inherently incapable of operating at a frequency in excess of 500 MHz.

According to the present invention there is provided a phase-lock loop clock extractor for extracting a clock frequency of N/2 cycles per second from a transmitted pulse code modulated (PCM) data signal of N bits per second, the clock extractor including a voltage controlled oscillator (VCO) for generating a clock signal of the desired frequency, a circuit connected to receive the transmitted data signal and produce a pulse signal on each transition of the data signal from one logic level to another and vice versa, a phase detector for comparing the VCO output with the pulse signal produced by said circuit and means connected to the phase detector for producing a control signal which is usable to adjust the frequency generated by the VCO, wherein the phase detector comprises a first switching circuit operable on each half cycle of the VCO frequency to route said pulse signal to second and third switching circuits, each of the second and third switching circuits having first and second outputs, each of the second and third switching circuits being operable on each half cycle of the VCO frequency which has been delayed by a predetermined amount compared with the VCO frequency applied to the first switching circuit, to produce pulse trains on their first and second outputs, the pulses in each pulse train comprising complementary parts of the pulses routed to the second or third switching circuit by the first switching circuit, corresponding first parts of the pulses appearing on the first output of the second and third switching circuits being combined to form a first output signal and corresponding second parts of the pulses appearing on the second output of the second and third switching circuits being combined to form a second output signal, said first and second output signals being used by said means to produce the control signal.

The VCO signal applied to the second and third switching circuits may be delayed by approximately a quarter of the period of the VCO.

The clock extractor in accordance with the present invention is of simple construction and can produce the desired VCO frequency without resorting to frequency multiplication techniques which would complicate the circuit construction. Such a frequency multiplying technique is disclosed in a paper entitled "Demultiplexer using fast hybrid integrated ECL-gates for 1 Gbit/s PCM signals" by Reinhard Petschacher and Peter Russer and presented at the 7th European Microwave Conference. The technique proposed involves using two frequency doubler stages between the VCO and phase detector in a phase lock loop.

The present invention also provides a P.C.M. transmission system including at least one regenerator having a phase-lock loop clock extractor in accordance with the present invention and a decision circuit for retiming the signal received by the regenerator, the decision circuit comprising first and second four-input port multiplexers each having an output, the odd numbered input ports of the first multiplexer and the even numbered input ports of the second multiplexer being coupled to a signal input of the decision circuit, a connection from an output of the first multiplexer to its even numbered input ports, a connection from an output of the second multiplexer to its odd numbered input ports, a clock input of each of the first and second multiplexers being coupled to the VCO, the output of which is phased so that the zero cross over occurs substantially midway through the bit period, and switching means connected to the outputs of the first and second multiplexers for selecting said outputs alternately, on each zero cross over of the clock signal, to produce a retimed P.C.M. signal on its output.

The switching means may comprise a further four-input port multiplexer, in which case the VCO signal applied to its clock input is delayed compared with that applied to the first and second multiplexers.

A decision circuit is known which is based on a D-type flip-flop arrangement in which the data presented to the input at the moment of each positive transition of the clock is stored, regenerated and delivered to the output for a whole bit period. A high speed data stream of say 1 Gigabits/second would require the same clock frequency and as explained such circuits cannot be fabricated in current ECL logic and therefore a decision circuit based on multiplexers is one way of retiming signals at such high bit rates.

The system may further comprise a further regenerator including a limiting amplifier for restandardising the amplitude of the signal received by the regenerator. Such a limiting amplifier may comprise a multiplexer having an even number of input ports, a clock input and an output, wherein the odd numbered input ports are maintained at one logic level, the even numbered input ports are maintained at a second logic level and the clock input is connected to receive the P.C.M. signal to be restandardised.

The described limiting amplifier based on a multiplexer has been found to improve the "eye" opening of the signal on the input.

The present invention also relates to a P.C.M. transmission system including a receiver having a demultiplexer and a phase lock loop clock extractor in accordance with the present invention, the demultiplexer comprising an input and K multiplexers, each multiplexer having a gain greater than one, K input ports, an output and a clock signal input, the clock signal inputs being coupled together and to the VCO output which is phased such that the zero cross over of the clock signal occurs midway through a data time slot period, the input of the demultiplexer being connected to the first input port of the first multiplexer, the second input port of the second multiplexer and so on till the Kth input port of the Kth multiplexer, the output of each multiplexer being connected to all the other of its input ports, whereby each multiplexer in turn samples the input for half a clock period and holds the signal occurring in the second half of the sampling period for (K−1) further sampling periods, that is (K−1)/2 clock periods.

In one embodiment of the invention K=4.

The demultiplexer described above is simpler in its construction than known demultiplexers which normally use a number of separate storage devices, such as flip-flops which are supplied with clock and data signals. In general either the data is phased appropriately at the storage devices which then use a common clock or data is supplied simultaneously to the storage devices and the clocks are phased appropriately. The correct phasing of clocks and data is achieved electronically or with predetermined delay lines which will operate at one prescribed frequency. Since the demultiplexer described used simultaneous data and simultaneous clocks, it does not require phase shifting devices and further it can operate at any frequency determined by the clock.

The present invention will now be described, by way of example, with reference to the accompanying drawings, wherein:

Figure 1 is a block schematic diagram of a PCM transmission system,

Figure 2 is a block schematic diagram of a limiting amplifier,

Figures 3A and 3B show the improved "eye" obtained by the limiting amplifier,

Figure 4 is a block schematic diagram of a decision circuit,

Figures 5(a) to (f) are waveform diagrams which assist in the understanding of the operation of the decision circuit shown in Figure 4,

Figure 6 is a block schematic circuit diagram of a phase-lock loop clock extractor,

Figure 7 is a schematic circuit diagram of a phase detector used in the clock extractor,

Figures 8(A) to 8(L) are waveform diagrams which assist in the understanding of the operation of the phase detector of Figure 7.

Figure 9 is a block schematic circuit diagram of a demultiplexer, and

Figures 10(A) to 10(F) are waveform diagrams which assist in the understanding of the operation of the demultiplexer of Figure 9.

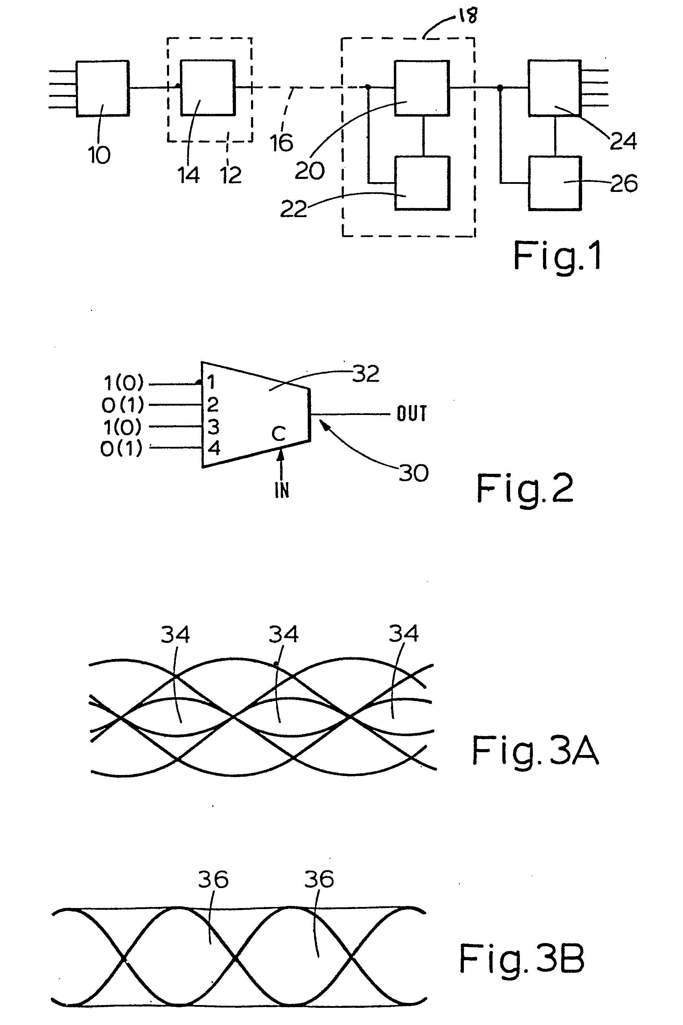

Figure 1 shows diagrammatically a signal transmission system including a multiplexer and transmitter shown collectively at 10; several regenerators 12 of which only one has been shown, each regenerator 12 including a limiting amplifier 14 for restandardising the transmitted signal in respect of amplitude; a further regenerator 18 including a decision circuit 20 for retiming, that is removing jitter in, and restandardising the signal, and a clock extraction phase detector 22 for deriving a clock signal from the transmitted data; and a receiver and demultiplexer 24 to which is connected a clock extraction phase detector 26.

The number of regenerators 12 and 18 in a line 16 depends amongst other things on the overall length of the line. Further it is not essential that each regenerator includes a decision circuit and a clock extraction phase detector because although it is necessary to restandardise a signal at each regenerator it is not always necessary to retime it.

An embodiment of a limiting amplifier 30 will now be described with reference to Figure 2. The amplifier 30 is based on a four input multiplexer circuit 32 which may comprise the circuit described with reference to Figure 6 of British Patent Specification No. 1,552,739. However unlike a customary multiplexer circuit which receives clock signals on its clock input c, in Figure 2 a pulse code modulated (PCM) data signal which has been distorted through transmission is applied to the clock input c. The four input ports 1 to 4 of the multiplexer 32 are held fixed with static voltages which in the case of a non-inverting limiting amplifier are arranged as follows ports 1 and 3—logical 1 and ports 2 and 4—logical 0. Thus on each transition of the data signal applied to the input $c$, a corresponding restandardising output is obtained, the sequence being unaltered.

Figure 3A shows an eye diagram of a distorted input data signal applied to the input $c$ of the multiplexer 32 and Figure 3B the output. It will be noted that the eyes 34 in the distorted data input signal are improved and given full amplitude as shown at 36 in the output from the limiting amplifier 30.

If it is desired to invert the data signal then this can be achieved by changing the static voltages on the ports 1 to 4 so that ports 1 and 3 are logical 0 and ports 2 and 4 are logical 1.

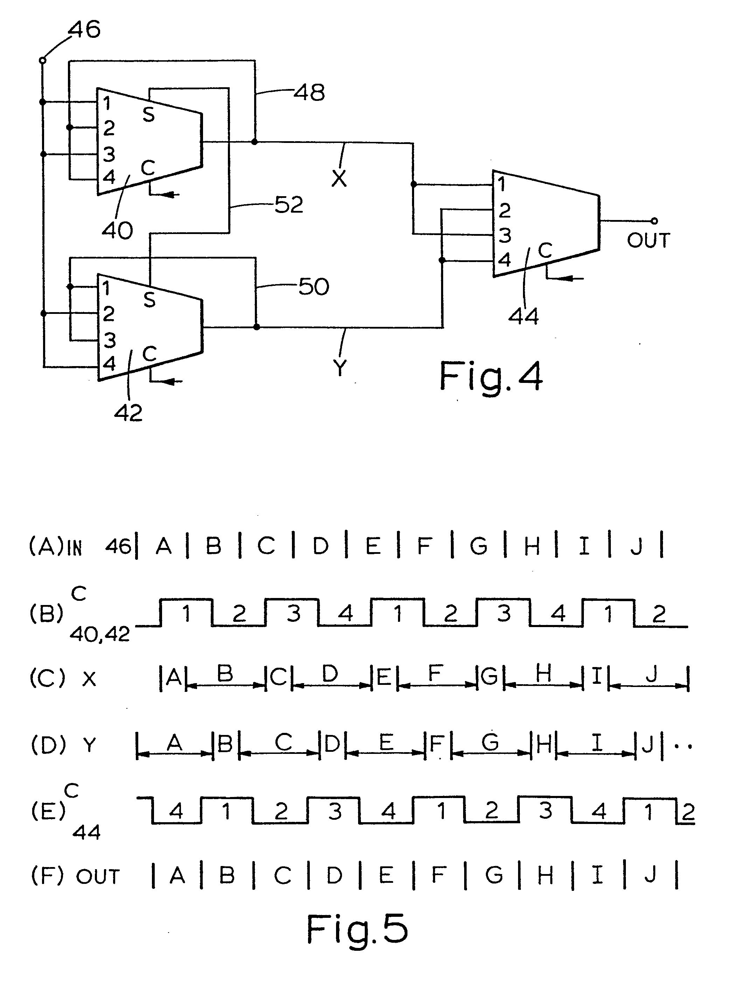

Figure 4 is a block schematic circuit diagram of an embodiment of a decision circuit which is able to operate with a clock frequency which is half the bit rate in the P.C.M. data stream, in other words a clock frequency of 600 MHz can be used with a 1.2 Gigabit/second data stream. This is made possible by using three 4-input port multiplexers 40, 42 and 44 which each have a forward gain greater than one and which are able to switch on each transition of a clock signal. Conveniently the multiplexers 40, 42 and 44 may be of the type disclosed in British Patent Specification 1,552,737.

The data signal to be restandardised and retimed is applied *via* an input terminal 46 to the input ports 1 and 3 of the multiplexer 40 and to the input ports 2 and 4 of the multiplexer 42. A feedback connection 48 connects an output X of the multiplexer 40 to its input ports 2 and 4, and feedback connection 50 connects an output Y of the multiplexer 42 to its input ports 1 and 3. The output X is applied to input ports 1 and 3 of the multiplexer 44 and the output Y is applied to input ports 2 and 4 of the multiplexer 44.

Corresponding clock signals are applied to the clock inputs $c$ of the multiplexers 40 and 42 and a delayed clock signal is applied to the clock input $c$ of the multiplexer 44. The clock signals in practice will be derived from the clock extraction phase detector to be described with reference to Figures 6 to 8. Optionally the sync inputs $s$ of the multiplexers 40, 42 may be interconnected by for example a conductor 52.

Figures 5(A) to (F) are timing diagrams illustrating the operation of the decision circuit of Figure 4. Figure 5(A) illustrates a data sequence A to J applied to the input terminal 46. The multiplexers 40 and 42 are clocked coherently (Figure 5(B)) so that correspondingly numbered input ports sample at the same time. As indicated in Figure 5(B) the clock is set with its half period equal in duration but staggered relative to the data time slots shown in Figure 5(A). With the input ports 1 selected, the multiplexer 40 samples the data, first in the time slot A and then in the time slot B so that at the start of the input ports 2 being selected the output X, Figure 5C, has assumed the data in the time slot B. With input ports 2 selected multiplexer 42 samples the data, first in the time slot B and then in the time slot C. At the start of the input ports 3 being selected, the output Y, Figure 5D, has become C. Simultaneously the multiplexer 40 has its input port 2 supplied from its output which was left with the data from the time slot B. By making the forward gain of the multiplexers 40, 42 greater than 1 then the data from time slot B will remain at X until input ports 3 are selected. Similarly the data from the time slot C remains at Y until input ports 4 are selected. In this manner the data from time slots B, D, F—appear at X and from time slots A, C, E—appear at Y, for durations exceeding a time slot.

The outputs X and Y are interleaved by the multiplexer 44 which receives a delayed clock signal, Figure 5(E), compared with the clock signal, Figure 5(B), applied to the multiplexers 40 and 42. The output, Figure 5(F), comprises a regenerated and retimed version of the data at the input 46. Retiming of the data streams X and Y occurs at each transition of the clock and the output time slot corresponds to a half-period of the clock, hence the clock frequency needs only to be half that of the bit rate.

The clock signal is derived from the incoming data stream using a phase lock loop clock extractor of the type shown in Figure 6. The clock extractor is based on a conventional phase-lock loop clock extractor but includes a phase detector 60 capable of extracting a clock signal at half the data frequency, which clock signal can be used to operate the decision circuit of Figure 4. The phase detector will be described with reference to Figure 7.

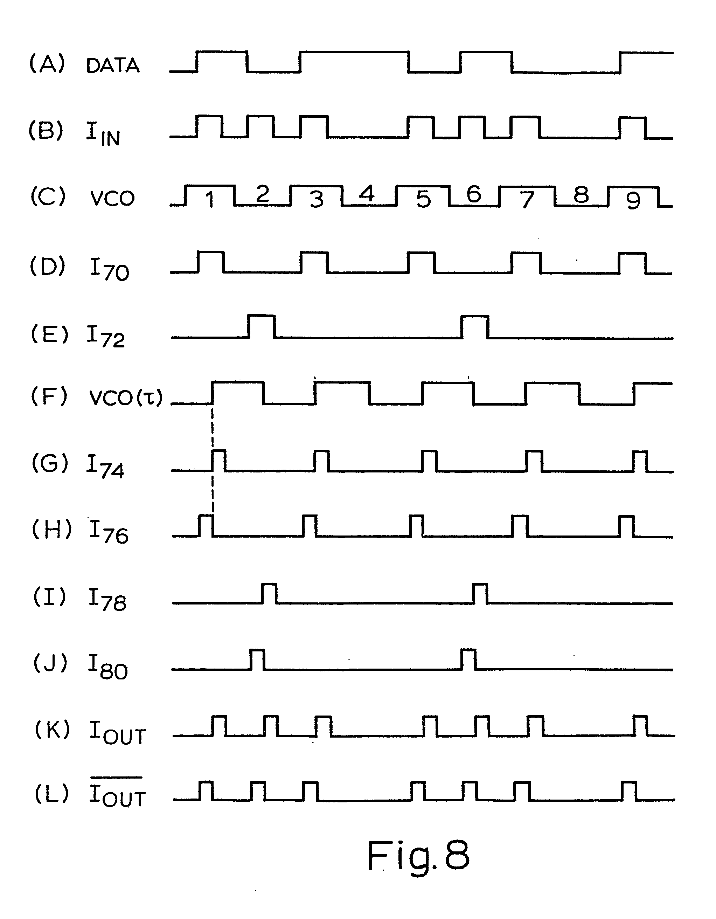

Referring initially to Figure 6 and some of the waveforms shown in Figure 8, incoming data signal, Figure 8A, applied to an input terminal 56 passes to a differentiating and rectifying circuit 58 which produces a pulse on each change or transition of the data signal, Figure 8B. These pulses are applied to one input of the phase detector 60 which has a second input to which is applied a signal from a voltage controlled oscillator (VCO) 62. In the present case the VCO 62 produces a signal at half the bit rate. The phase detector 60 mixes the signals applied to its inputs. If there is an error in phase then an output signal is applied to a low pass filter 64. The signal from the filter 64 is amplified in an amplifier 66 and is applied as a correction voltage to adjust the output frequency of the VCO 62. The output clock signal is derived from a terminal 68. For one particular phase of the clock, the phase detector 60 gives zero output and the loop locks.

Referring now to Figures 7 and 8, the phase detector 60 comprises three pairs of long-tailed pair connected NPN transistors 70, 72, 74, 76 and 78, 80 and two delay circuits 82, 84. These devices are connected together in the following manner. The signal, Figure 8B, from the differentiating and rectifying circuit 58 is applied to an input terminal 86 which is connected to the junction of the emitters of the transistors 70, 72. The VCO signal and $\overline{VCO}$ signal are applied *via* input terminals 88, 90, respectively, to the bases of the transistors 70, 72. The collectors of the transistors 70, 72 are connected, respectively, to the junctions of the emitters of the transistors 74, 76 and 78, 80. The delay circuit 82 is connected between the terminal 88 and the bases of the transistors 74, 80 and the delay circuit 84 is connected between the terminal 90 and the bases of the transistors 76, 78. The collectors of the transistors 74, 78 are connected together and to an $I_{OUT}$ terminal 92 and the collectors of the transistors 76 and 80 are connected to an $\overline{I_{OUT}}$ terminal 94.

In operation the VCO and $\overline{VCO}$ signals are applied respectively to the terminals 88, 90. The VCO signal is illustrated in Figure 8C but the $\overline{VCO}$ signal has not been shown because it is simply the inversion of the $\overline{VCO}$ signal. When emitter current $I_{IN}$ is flowing at terminal 86 then either the transistor 70 or 72 will conduct, depending on whichever transistor 70, 72 has the higher base voltage to provide current $I_{70}$, Figure 8D, and $I_{72}$, Figure 8E, on one or other collector, respectively. The VCO and $\overline{VCO}$ signals are delayed by approximately 90° of phase in the circuits 82 and 84—for convenience only VCO ($\tau$) has been shown in Figure 8F. Assuming that the VCO signal is in phase, then the transitions in the VCO ($\tau$) signal will occur substantially midway through any $I_{70}$ or $I_{72}$ pulses. Whenever the current $I_{70}$, $I_{72}$ is flowing in the emitters of the transistor pairs 74, 76, 78 and 80, then the transistors 74, 76, 78 and 80 will conduct, depending on whichever transistor has a high base voltage, to provide the currents $I_{74}$, $I_{76}$, $I_{78}$ and $I_{80}$ on their collectors as shown in Figures 8G to 8J. The signals from the collectors of the transistors 74, 78 are combined to form the $I_{OUT}$ signal, Figure 8K, on the terminal 92 and in a similar way an $\overline{I_{OUT}}$ signal on the terminal 94 is formed by combining the signals on the collectors of the transistors 76, 80.

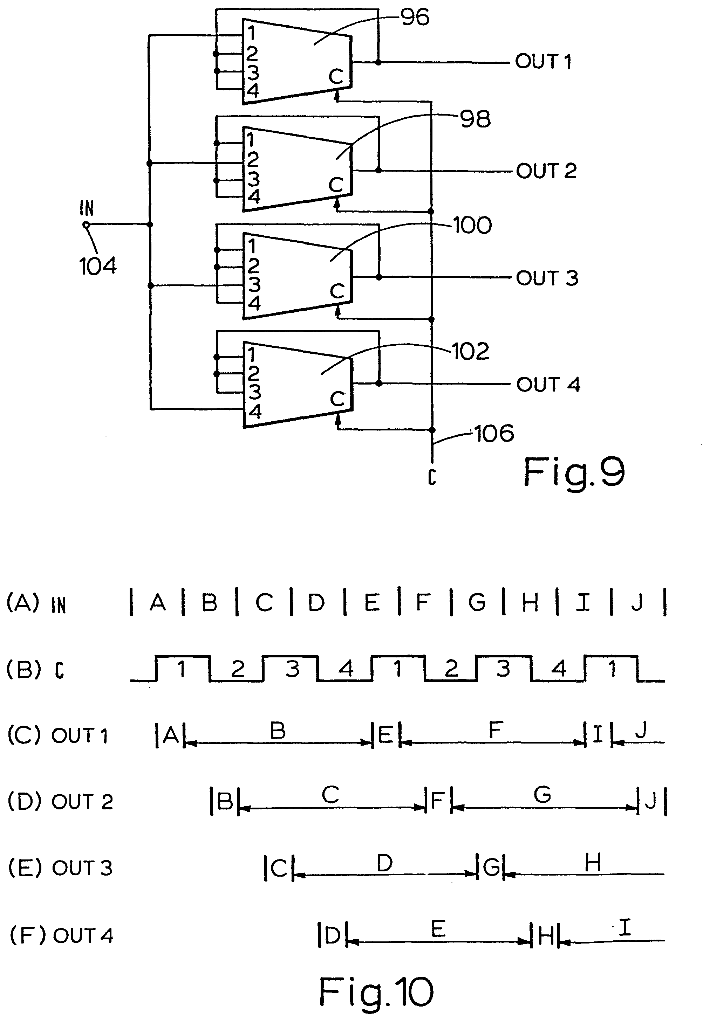

Figure 9 illustrates schematically a demultiplexing circuit which is able to recover data which has been transmitted at a certain bit rate, e.g. 1.2 Gigabits/second, using a clock signal derived from the incoming data and having a frequency half that of the bit rate e.g. 600 MHz.

The demultiplexer of Figure 9 comprises four four-input multiplexers 96, 98, 100 and 102 of a suitable type, for example as disclosed in Figure 6 of British Patent Specification 1,552,739, which can be switched on each transition of a clock signal. The incoming data on input terminal 104 is applied to input port 1 of multiplexer 96, input port 2 of multiplexer 98, input port 3 of multiplexer 100 and input port 4 of multiplexer 102. The remainder of the input ports of each multiplexer are connected together and are coupled to the output of the associated multiplexer by a feedback connection. As shown the clock signal is applied *via* a line 106 to all the clock inputs *c* of the multiplexers 96 to 102. Each of the multiplexers 96 to 102 has an output for its respective channel and for convenience these have been referenced OUT1, 2, 3 and 4.

plexer of Figure 9 it must be remembered that the multiplexers 96 to 102 are synchronised so that the inputs of each multiplexer are selected coherently. Each input port of all the multiplexers 96 to 102 is selected in turn for a half period of the common clock on the line 106. Data is sent in common to input port 1 of the multiplexer 96, input port 2 of the multiplexer 98, input port 3 of the multiplexer 100 and input port 4 of the multiplexer 102. The remaining three input ports of each multiplexer are commoned and fed from their output.

Referring now to Figure 10, consider the data sequence, Figure 10A, defined by time slots A—J. The clock, Figure 10B, is set with its half period equal in duration but staggered with respect to the data time slot. With input ports 1 selected, the multiplexer 96 samples the data, first in the time slot A and then in the time slot B so that at the start of input ports 2 being selected, OUT1, Figure 10C, is set to the data of time slot B. With input ports 2 selected, the multiplexer 98 samples the data, first in the time slot B and then in the time slot C. At the start of input ports 3 being selected, OUT2, Figure 10D, has been set to the data in time slot C. Simultaneously the multiplexer 96 has its input port 2 supplied from its output which was left with data from time slot B. If all the multiplexers have a forward gain greater than 1 then the data from the time slot B will remain at OUT1 until input 1 is next selected (i.e. during the time slot E). Similarly OUT2, Figure 10D, OUT3, Figure 10E and OUT4, Figure 10F, will be set to C, D and E as shown. As is apparent the data input stream is dispersed into four parallel channels where OUT1 acquires data from the time slots B, F, ..., OUT2 acquires data from slots C, G, ..., OUT3 acquires data from time slots D, H, ..., and OUT4 acquires data from time slots E, I .... Hence a 1.2 Gigabit/second data stream can be demultiplexed with a 600 MHz clock.

## Claims

1. A phase-lock loop clock extractor for extracting a clock frequency of N/2 cycles per second from a transmitted pulse code modulated (PCM) data signal of N bits per second, the clock extractor including a voltage controlled oscillator (VCO) (62) for generating a clock signal of the desired frequency, a circuit (58) connected to receive the transmitted data signal and produce a pulse signal on each transition of the data signal from one logic level to another and vice versa, a phase detector (60) for comparing the VCO output with the pulse signal produced by said circuit (58) and means (64, 66) connected to the phase detector (60) for producing a control signal which is usable to adjust the frequency generated by the VCO (62), wherein the phase detector (60) comprises a first switching circuit (70, 72) operable on each half cycle of the VCO frequency to route said pulse signal to second and third switching circuits (74, 76 and 78, 80), each of the second and third switching circuits having first and second outputs, each of the second and third switching circuits (74, 76 and 78, 80) being operable on each half cycle of the VCO frequency which has been delayed by a predetermined amount compared with the VCO frequency applied to the first switching circuit (70, 72), to produce pulse trains on their first and second outputs, the pulses in each pulse train comprising complementary parts of the pulses routed to the second or third switching circuit (74, 76 or 78, 80) by the first switching circuit (70, 72), corresponding first parts of the pulses appearing on the first output of the second and third switching circuits (74, 76 and 78, 80) being combined to form a first output signal ($I_{OUT}$) and corresponding second parts of the pulses appearing on the second output of the second and third switching circuits (74, 76, 78, 80) being combined to form a second output signal ($\overline{I_{OUT}}$), said first and second output signals being used by said means to produce the control signal.

2. A clock extractor as claimed in Claim 1, characterised in that the VCO signal applied to the second and third switching circuits is delayed by approximately a quarter of the period of the VCO by delay devices (82, 84).

3. A P.C.M. transmission system characterised by at least one regenerator having a phase-lock loop clock extractor as claimed in Claim 1 or 2, and a decision circuit (Figure 4) for retiming the signal received by the regenerator, the decision circuit comprising first and second four-input port multiplexers (40, 42) each having an output (X, Y), the odd numbered input ports of the first multiplexer (40) and the even numbered input ports of the second multiplexer (42) being coupled to a signal input (46) of the decision circuit, a connection (48) from the output of the first multiplexer to its even numbered input ports, a connection (50) from the output of the second multiplexer to its odd numbered output ports, a clock input (c) of each of the first and second multiplexers (40, 42) being coupled to the VCO (62), the output of which is phased so that the zero cross over occurs substantially midway through the bit period, and switching means (44) connected to the outputs (X, Y) of the first and second multiplexers (40, 42) for selecting said outputs (X, Y) alternately, on each zero cross over of the clock signal, to produce a retimed P.C.M. signal on its output.

4. A system as claimed in Claim 3, in which the switching means comprises a further four-input port multiplexer (44) and in which the VCO signal applied to its clock input is delayed compared with that applied to the first and second multiplexers.

5. A system as claimed in Claim 3 or 4, characterised by a further regenerator (Figure 2) including a limiting amplifier for restandardising the amplitude of the signal received by the regenerator, the limiting amplifier comprising a multiplexer (32) having an even number of input ports, a clock input (c) and an output, wherein the odd numbered input ports are maintained at one logic level, the even numbered input ports are maintained at a second logic level and the clock input is connected to receive the P.C.M. signal to restandardised.

6. A P.C.M. transmission system characterised by a receiver having a demultiplexer (Figure 9) and a phase-lock loop clock extractor as claimed in Claim 1 or 2, the demultiplexer comprising an input (104) and K multiplexers (96, 98, 100 and 102), each multiplexer having a gain greater than one, K input ports, an output (OUT) and a clock signal input (c), the clock signal inputs being coupled together and to the VCO output (68—Figure 6) which is phased such that the zero cross over of the clock signal occurs midway through a data time slot period, the input (104) of the demultiplexer being connected to the first input port of the first multiplexer (96), the second input port of the second multiplexer (98) and so on till the Kth input port of the Kth multiplexer, the output of each multiplexer being connected to all the other of its input ports, whereby each multiplexer in turn samples the input for half a clock period and holds the signal occurring in the second half of the sampling period for (K—1) further sampling periods, that is (K—1)/2 clock periods.

**Patentansprüche**

1. Ein Taktextrahierer in Form einer phasenverriegelten Schleife zum Extrahieren einer Taktfrequenz von N/2 Hz aus einem übertragenen pulskodemodulierten (PCM) Datensignal von N Bits/Sekunde, wobei der Taktextrahierer einen spannungsgeregelten Oszillator (VCO) (62) zum Erzeugen eines Taktsignals mit der gewünschten Frequenz, eine Schaltungsanordnung (58) zum Empfangen des übertragenen Datensignals und zum Erzeugen eines Impulssignals bei jedem Übergang des Datensignals von dem einen Logischen Pegel zu dem anderen und umgekehrt, einen Phasendetektor (60) zum Vergleichen des VCO-Ausgangssignals mit dem von der genannten Schaltungsanordnung (58) erzeugten Impulssignal und Mittel (64, 66) enthält, die mit dem Phasendetektor (60) verbunden sind zum Erzeugen eines Regelsignals, das zur Einstellung der von dem VCO (62) erzeugten Frequenz dient, dadurch gekennzeichnet, dass der Phasendetektor (60) einen ersten Schaltkreis (70, 72) enthält, der bei jeder halben Periode der VCO-Frequenz arbeitet, um das genannte Impulssignal zu zweiten und dritten Schaltkreisen (74, 76 und 78, 80) zu zuführen, wobei jeder der zweiten und dritten Schaltkreise erste und zweite Ausgänge hat und wobei jeder der zweiten und dritten Schaltkreise (74, 76 und 78, 80) bei jeder halben Periode der VCO-Frequenz, die um einen vorbestimmten Betrag im Vergleich zu der dem ersten Schaltkreis (70, 72) zugeführten VCO-Frequenz verzögert ist, wirksam wird zum Erzeugen von Impulsfolgen an ihren ersten und zweiten Ausgängen, wobei die Impulse in jeder Impulsfolge komplementäre Teile der Impulse enthalten, die dem zweiten und dritten Schaltkreis (74, 76 oder 78, 80) durch den ersten Schaltkreis (70, 72) zugeführt werden, wobei entsprechende erste Teile der Impulse, die an dem ersten Ausgang der zweiten und dritten Schaltkreise (74, 76 und 78, 80) auftreten, kombiniert werden zum Bilden eines ersten Ausgangssignals ($I_{OUT}$) und entsprechende zweite Teile der Impulse, die an dem zweiten Ausgang der zweiten und dritten Umschaltkreise (74, 76 und 78, 80) auftreten, kombiniert werden zum Bilden eines zweiten Ausgangssignals ($I_{\overline{OUT}}$), wobei diese ersten und zweiten Ausgangssignale von den genannten Mitteln zum Erzeugen des Regelsignals benutzt werden.

2. Taktextrahierer nach Anspruch 1, dadurch gekennzeichnet, dass das den zweiten und dritten Schaltkreisen zugeführte VCO-Signal um nahezu ein Viertel der Periode des VCO-Signals durch Verzögerungs-anordnungen (82, 84) verzögert wird.

3. Ein PCM-Übertragungssystem, gekennzeichnet durch wenigstens einen Regenerator mit einem Taktextrahierer in Form einer phasenverriegelten Schleife nach Anspruch 1 oder 2, und mit einem Entscheidungskreis (Fig. 4) zum zeitlichen Korrigieren des von dem Regenerator empfangenen Signals, wobei der Entscheidungskreis erste und zweite Multiplexer (40, 42) mit vier Eingangstoren und mit je einem Ausgang (X, Y) enthält, wobei die ungeradzahligen Eingangstore des ersten Multiplexers (40) und die geradzahligen Eingangstore des zweiten Multiplexers (42) gekoppelt sind mit einem Signaleingang (46) des Entscheidungskreises, weiterhin mit einer Verbindung (48) von dem Ausgang des ersten Multiplexers zu seinen ungeradzahligen Eingangstoren, einer Verbindung (50) von dem Eingang des zweiten Multiplexers zu seinen ungeradzahligen Eingangstoren, wobei ein Takteingang (c) jedes der ersten und zweiten Multiplexer (40, 42) mit dem VCO (62) gekoppelt ist, wobei der Ausgang desselben derart phasenverschoben ist, dass der Nulldurchgang im wesentlichen in der Mitte der Bitperiode auftritt und wobei Schaltmittel (44) mit den Ausgängen (X, Y) der ersten und zweiten Multiplexer (40, 42) verbunden sind, um bei jedem Nulldurchgang des Taktsignals die genannten Ausgänge (X, Y) wechselweise zu selektieren zum Erzeugen eines zeitlich korrigierten PCM-Signals an dem Ausgang.

4. Ein System nach Anspruch 3, wobei die Schaltmittel einen weiteren Multiplexer (44) mit vier Eingangstoren enthalten und wobei das dem Takteingang zugeführte VCO-Signal im Vergleich zu dem den ersten und zweiten Multiplexern zugeführten Signal verzögert ist.

5. Ein System nach Anspruch 3 oder 4, gekennzeichnet durch einen weiteren Regenerator (Fig. 2) mit einem Begrenzungsverstärker zum Neustandardisieren der Amplitude des von dem Regenerator empfangenen Signals, wobei der Bregrenzungsverstärker einen Multiplexer (32) mit einer geraden Anzahl Eingangstore, einen Taktimpulseingang (c) und einen Ausgang enthält, wobei die ungeradzahligen Eingangstore auf dem einen logischen Pegel gehalten werden und die geradzahligen Eingangstore auf einem zweiten logischen Pegel gehalten werden und der Takteingang zum Erhalten des neuzustandardisierenden PCM-Signals verbunden ist.

6. Ein PCM-Übertragungssystem, gekennzeichnet durch einen Empfänger mit einem Demultiplexer (Fig. 9) und mit einem Taktextrahierer in Form einer phasenverriegelten Schleife nach Anspruch 1 oder 2, wobei der Demultiplexer einen Eingang (104) und K Multiplexer (96, 98, 100 und 102) enthält, wobei jeder Multiplexer eine Verstärkung grösser als eins, K Eingangstore, einen Ausgang (OUT) und einen Taktsignaleingang (c) enthält, wobei die Taktsignaleingänge miteinander und mit dem VCO-Ausgang (68—Fig. 6) verbunden sind, der derart phasenverschoben ist, dass der Nulldurchgang des Taktimpulssignals in der Mitte der Datenzeitschlitzperiode auftritt, wobei der Eingang (104) des Demultiplexers mit dem ersten Eingangstor des ersten Multiplexers (96), dem zweiten Eingangstor des zweiten Multiplexers (98) und so weiter bis zum K. Eingangstor des K. Multiplexers verbunden ist, wobei der Ausgang jedes Multiplexers mit allen anderen seiner Eingangstore verbunden ist, wobei jeder Multiplexer der Reihe nach während einer halben Taktperiode den Eingang abtastet und das in der zweiten Hälfte der Abtastperiode auftretende Signal für (K—1) weither Abtastperioden, d.h. (K—1)/2 Taktperioden, festhält.

## Revendications

1. Extracteur d'horloge à boucle de verrouillage de phase pour extraire une fréquence d'horloge de N/2 cycles par seconde d'un signal de données modulé par impulsions codées transmis de N bits par seconde, l'extracteur d'horloge comprenant un oscillateur VCO à fréquence réglée par variation de tension (62) pour produire un signal d'horloge de la fréquence souhaitée, un circuit (58) connecté pour recevoir le signal de données transmis et produire un signal d'impulsion à chaque transition du signal de données d'un niveau logique à un autre et inversement, un détecteur de phase (60 pour comparer le signal de sortie de l'oscillateur VCO au signal d'impulsion produit par le circuit (58) et des moyens (64, 66) connectés au détecteur de phase (60) pour produire un signal de commande pouvant être utilisé pour régler la fréquence produire par l'oscillateur VCO (62), dans lequel le détecteur de phase (60) comprend un premier circuit de commutation (70, 72) pouvant agir sur chaque demicycle de la fréquence de l'oscillateur VCO en vue d'aiguiller le signal d'impulsion vers un deuxième et un troisième circuit de commutation (74, 76 et 78, 80), le deuxième et le troisième circuit de commutation (74, 76 et 78, 80) comportant chacun une première et une deuxième sortie et pouvant agir chacun sur chaque demicycle de la fréquence de l'oscillateur VCO dont le signal de sortie a été retardé dans une mesure prédéterminée par rapport au signal de sortie de l'oscillateur VCO appliqué au premier circuit de commutation (70, 72) en vue de produire des trains d'impulsions sur leur première et leur deuxième sortie, les impulsions de chaque train d'impulsions comprenant des parties complémentaires des impulsions aiguillées vers le deuxième ou le troisième circuit de commutation (74, 76 ou 78, 80) par le premier circuit de commutation (70, 72), des premières parties correspondantes des impulsions apparaissant sur la première sortie du deuxième et du troisième circuit de commutation (74, 76 et 78, 80) étant combinées pour former un premier signal de sortie ($I_{OUT}$) et des secondes parties correspondantes des impulsions apparaissant sur la seconde sortie du deuxième et du troisième circuit de commutation (74, 76 et 78, 80) étant combinées pour former un second signal de sortie ($I_{\overline{OUT}}$) le premier et le second signal de sortie étant utilisés par lesdits moyens pour produire le signal de commande.

2. Extracteur d'horloge suivant la revendication 1, caractérisé en ce que le signal VCO appliqué au deuxième et au troisième circuit de commutation est retardé d'environ un quart de la période de la fréquence de l'oscillateur VCO par des dispositifs à retard (82, 84).

3. Système de transmission à modulation par impulsions codées caractérisé par au moins un régénérateur comportant un extracteur d'horloge à boucle de verrouillage de phase suivant la revendication 1 ou 2, et un circuit de décision (Fig. 4) pour resynchroniser le signal reçu par le régénerateur, le circuit de décision comprenant un premier et un second multiplexeur à quatre accès d'entrée (40, 42) comportant chacun une sortie (X, Y), les accès d'entrée impairs du premier multiplexeur (40) et les accès d'entrée pairs du second multiplexeur (42) étant couplés à une entrée de signal (46) du circuit de décision, une connexion (48) allant de la sortie du premier multiplexeur à ses ports d'entrée pairs, une connexion (50) allant de la sortie du second multiplexeur à ses ports d'entrée impairs, une entrée d'horloge (c) du premier et du second multiplexeur (40, 42) étant couplée à l'oscillateur VCO (62) dont la phase du signal de sortie est telle que le passage par zéro se produit pratiquement au milieu de la période de bit, et des moyens de commutation (44) connectés aux sorties (X, Y) du premier et du second multiplexeur (40, 42) pour sélectionner lesdites sorties (X, Y) en alternance à chaque passage par zéro du signal d'horloge en vue de produire sur sa sortie, un signal de modulation par impulsions codées resynchronisé.

4. Système suivant la revendication 3, caractérisé en ce que les moyens de commutation comprennent un autre multiplexeur à quatre accès d'entrée (44) et le signal VCO appliqué à son entrée d'horloge est retardé par rapport à celui appliqué au premier et au deuxième multiplexeur.

5. Système suivant la revendication 3 ou 4, caractérisé par un autre régénerateur (Fig. 2) comprenant un amplificateur limiteur pour remettre en forme l'amplitude du signal reçu par le régénerateur, l'amplificateur limiteur comprenant un multiplexeur (32) comportant un nombre pair d'accès d'entrée, une entrée d'horloge (C) et une sortie, les accès d'entrée impairs étant maintenus à un premier niveau logique, les accès d'entrée pairs étant maintenus à un second niveau logique et l'entrée d'horloge étant connectée pour recevoir le signal de modulation par impulsions codées à remettre en forme.

6. Système de transmission à modulation par impulsions codées, caractérisé par un récepteur comportant un démultiplexeur (Fig. 9) et un extracteur d'horloge à boucle de verrouillage de phase suivant la revendication 1 ou 2, le démultiplexeur comprenant une entrée (104) et K multiplexeurs (96, 98, 100 et 102), chaque multiplexeur présentant un gain supérieur à un, K ports d'entrée, une sortie (OUT) et une entrée (c) de signal d'horloge, les entrées de signal d'horloge étant couplées entre elles ainsi qu'à la sortie de l'oscillateur VCO—(68—Fig. 6) dont la phase du signal de sortie est telle que le passage par zéro du signal d'horloge se produit au milieu d'une période de tranche de temps de données, l'entrée (104) du démultiplexeur étant connectée au premier accès d'entrée du premier multiplexeur (96), au deuxième accès d'entrée du deuxième multiplexeur et ainsi de suite jusqu'au k-ième accès d'entrée du k-ième multiplexeur, la sortie de chaque multiplexeur étant connectée à tous ses autres accès d'entrée de sorte que chaque multiplexeur échantillonne, à son tour, l'entrée pendant une demi-période d'horloge et maintient le signal qui se présente dans la seconde moitié de la période d'échantillonnage pendant (K—1) autres périodes d'échantillonnage, c'est-à-dire (K—1)/2 périodes d'horloge.

Fig.1

Fig.2

Fig.3A

Fig.3B

Fig.4

(A) IN 46 | A | B | C | D | E | F | G | H | I | J |

(B) $\overset{C}{_{40,42}}$ ⎍ 1 ⎍ 2 ⎍ 3 ⎍ 4 ⎍ 1 ⎍ 2 ⎍ 3 ⎍ 4 ⎍ 1 ⎍ 2

(C) X |A| ← B → |C| ← D → |E| ← F → |G| ← H → |I| ← J → |

(D) Y | ← A → |B| ← C → |D| ← E → |F| ← G → |H| ← I → |J| ··

(E) $\overset{C}{_{44}}$ ⎍ 4 ⎍ 1 ⎍ 2 ⎍ 3 ⎍ 4 ⎍ 1 ⎍ 2 ⎍ 3 ⎍ 4 ⎍ 1 ⎍ 2

(F) OUT | A | B | C | D | E | F | G | H | I | J |

Fig.5

2

**Fig.6**

**Fig.7**

(A) DATA

(B) $I_{IN}$

(C) VCO    1  2  3  4  5  6  7  8  9

(D) $I_{70}$

(E) $I_{72}$

(F) VCO($\tau$)

(G) $I_{74}$

(H) $I_{76}$

(I) $I_{78}$

(J) $I_{80}$

(K) $I_{OUT}$

(L) $\overline{I_{OUT}}$

# Fig.8

0 027 289

Fig.9

| (A) IN | A | B | C | D | E | F | G | H | I | J |

(B) C   1  2  3  4  1  2  3  4  1

(C) OUT 1   |A| ← B → |E| ← F → |I| J

(D) OUT 2   |B| ← C → |F| ← G → |J|

(E) OUT 3   |C| ← D → |G| ← H

(F) OUT 4   |D| ← E → |H| ← I

Fig.10